# FASCICULE DE BREVET EUROPEEN

(11) **EP 4 764 508 B1**
(45) Date de publication et mention de la délivrance du brevet: **02.12.2026**
(21) Numéro de dépôt: 25224513.9
(22) Date de dépôt: 17.12.2025
(51) Int. Cl.: G01R 11/25, G01R 19/25, G01R 22/06, G01R 22/10, G01R 31/327

(54) **COMPTEUR ÉLECTRIQUE COMPORTANT UN RELAI DE PUISSANCE ET PROCÉDÉ DE SURVEILLANCE DU RELAI DE PUISSANCE D'UN COMPTEUR ÉLECTRIQUE**
ELEKTRIZITÄTSZÄHLER MIT LEISTUNGSRELAIS UND VERFAHREN ZUR ÜBERWACHUNG DES LEISTUNGSRELAIS EINES ELEKTRIZITÄTSZÄHLERS
ELECTRIC METER COMPRISING A POWER RELAY AND METHOD FOR MONITORING THE POWER RELAY OF AN ELECTRIC METER

(30) Priorité: 18.12.2024 FR 2414479
(43) Date de publication de la demande: 24.06.2026
(73) Titulaire: SAGEMCOM ENERGY & TELECOM SAS, 92270 Bois-Colombes (FR)
(72) Inventeur: GRINCOURT, Christophe, 92270 Bois-Colombes (FR); JEANROT, Marc, 92270 Bois-Colombes (FR)
(74) Mandataire: Novagraaf Technologies

(56) Documents cités:
- EP-B1- 3 583 432
- WO-A1-2010/149921
- WO-A1-2013/127966
- US-A1- 2022 065 907
- US-A1- 20240 120 771
- US-A1- 20240 339 825

## Description

### Domaine technique

Les différents exemples de réalisation décrits dans la présente divulgation concernent un compteur électrique comportant un relai de puissance destiné à être connecté en amont à un réseau électrique et en aval à une installation. Ils concernent également une méthode de surveillance du relai de puissance d'un tel compteur électrique.

### Arrière plan

Un compteur électrique comporte classiquement un relai de puissance pouvant être fermé ou ouvert afin de gérer la connexion entre un réseau électrique et une installation électrique. Ce relai de puissance peut être amené à chauffer, par exemple en cas de fort courant. Une température extrême du relai de puissance peut mettre le feu au compteur.

Il est connu de l'état de la technique de surveiller la température dans le compteur et de générer des alertes lorsqu'elle dépasse un certain seuil. Ces méthodes dépendent de la température externe et sont donc imprécises. Le document WO2013/127966A1 divulgue un compteur d'énergie électrique.

Il existe un besoin pour une méthode de surveillance qui permette de détecter une température anormale du relai de puissance de façon plus précise.

### Résumé

Les revendications indépendantes définissent plusieurs aspects de la présente divulgation. De plus d'autres aspects ou modes de réalisation sont définis dans les revendications dépendantes.

Un premier aspect de la présente divulgation concerne un procédé de surveillance d'un dispositif électrique destiné à être monté entre réseau électrique et une installation électrique. Le réseau électrique délivre un signal électrique à une ou plusieurs phases. Le dispositif électrique décrit ici comporte au moins :
- pour chaque phase, un capteur de courant monté en série avec un relai de puissance et destiné à mesurer un courant circulant dans le relai de puissance lorsqu'il est fermé, le capteur de courant étant destiné à être connecté au réseau électrique en un point amont et le relai de puissance étant destiné à être connecté à l'installation en un point aval,
- pour chaque phase, un premier capteur de tension monté au point amont pour mesurer une tension amont,
- pour chaque phase, un second capteur de tension monté au point aval pour mesurer une tension aval,
- au moins un convertisseur analogique-numérique, configuré pour obtenir, pour chaque phase, à une pluralité d'instants de mesure sur une ou plusieurs périodes de mesure, des échantillons de la tension amont, de la tension aval et du courant, et
- un modem de transmission.

Le procédé de surveillance du dispositif comporte au moins les étapes suivantes :
- une détermination pour chaque phase, à partir des échantillons obtenus, de grandeurs dont le rapport est représentatif d'une valeur de résistance du relai de puissance pour la période de mesure,
- une génération d'alerte en fonction du rapport obtenu, et
- une transmission d'alerte via le modem de transmission.

Le procédé de surveillance estime la valeur de la résistance de contact du relai de puissance en temps réel, pour détecter un échauffement anormal du relai de puissance qui risquerait d'entraîner la création d'une flamme pouvant entraîner un incendie. Il permet de remonter une alarme avant que le risque d'incendie ne soit trop critique. Il permet aussi de disculper le compteur électrique d'une installation en cas d'incendie (si la valeur estimée de la résistance du relai de puissance est faible, cela prouve que le compteur n'est pas la cause de l'incendie).

Un avantage de ce procédé de surveillance est qu'il n'utilise pas de mesure de température. Les résultats obtenus sont plus précis que ceux obtenus avec des mesures de température et ils ne dépendent pas de la température extérieure. Un autre avantage est que le procédé peut être implémenté dans n'importe quel dispositif électrique ou compteur électrique puisqu'il utilise des mesures et des calculs réalisables à partir d'éléments électroniques et logiciel standard. Le procédé peut être mis en œuvre par ordinateur. Les compteurs qui sont déjà installés dans le réseau peuvent être mis à jour à distance pour disposer d'une version de logiciel adaptée à la mise en œuvre du procédé.

Dans un premier mode de réalisation du procédé de surveillance, les échantillons de tension amont, de tension aval et de courant sont obtenus à partir d'un même convertisseur analogique-numérique. Le procédé comporte alors :
- une détermination, pour chaque instant de mesure de chaque période de mesure, d'une différence entre une première fonction des échantillons de tension amont et une seconde fonction des échantillons de tension aval,
- une intégration des différences déterminées sur chaque période de mesure, pour obtenir une première grandeur représentative d'une tension aux bornes du relai de puissance pour chaque période de mesure,
- une intégration d'une troisième fonction des échantillons de courant sur chaque période de mesure, pour obtenir une seconde grandeur représentative du courant circulant dans le relai de puissance pour chaque période de mesure,
- un calcul d'un rapport entre la première et la seconde grandeur, ou entre une moyenne des premières et une moyenne des secondes grandeurs, pour obtenir la valeur de résistance du relai de puissance pour la ou les périodes de mesure.

Ce mode de réalisation est particulièrement précis mais nécessite que les échantillons soient obtenus par un même convertisseur analogique-numérique, les échantillons devant être synchrones pour calculer ladite différence.

Dans certains cas, notamment pour certains compteurs du parc existant, les échantillons sont obtenus à partir de plusieurs convertisseurs analogique-numérique, typiquement un premier convertisseur (par exemple avec une résolution de 24 bits) pour obtenir les échantillons de tension amont et de courant, et un second convertisseur (par exemple avec une résolution de 12 bits) pour les échantillons de tension aval. Dans ce cas, selon un second mode de réalisation, le procédé de surveillance comporte pour chaque phase:
- une intégration d'une première fonction des échantillons de tension amont sur chaque période de mesure pour obtenir une valeur représentative de la tension amont,
- une intégration d'une seconde fonction des échantillons de tension aval sur chaque période de mesure pour obtenir une valeur représentative de la tension aval,
- une détermination d'une différence entre la valeur représentative de la tension amont et la valeur représentative de la tension aval, pour obtenir une première grandeur représentative d'une tension aux bornes du relai de puissance pour chaque période de mesure,
- une intégration d'une troisième fonction des échantillons de courant sur chaque période de mesure, pour obtenir une seconde grandeur représentative du courant circulant dans le relai de puissance pour chaque période de mesure,
- un calcul d'un rapport entre la première et la seconde grandeur, ou entre une moyenne des premières et une moyenne des secondes grandeurs, pour obtenir la valeur de résistance du relai de puissance pour la ou les périodes de mesure.

Avantageusement, la première, la seconde et la troisième fonction comportent respectivement une multiplication des échantillons de tension amont, de tension aval et de courant, par respectivement un gain de tension amont, de tension aval et de courant.

Les gains sont déterminés pendant une phase de calibration, en usine, et permettent de compenser les erreurs introduites par l'imprécision des valeurs des composants utilisés dans les capteurs.

Les résultats obtenus dans le premier et le second mode de réalisation peuvent le cas échéant être améliorés en implémentant une ou plusieurs des étapes listées ci-dessous :
- ignorer les échantillons associés à une mesure de courant vulnérable au bruit.
- considérer plusieurs périodes de mesure, la moyenne des premières grandeurs et la moyenne des secondes grandeurs étant obtenue en appliquant un filtrage numérique sélectif de réponse impulsionnelle rectangulaire et de réponse en fréquence de forme sin(x)/x.
- utiliser une première, une seconde et une troisième fonction qui comportent respectivement un filtrage de Butterworth desdits échantillons, au moins du troisième ordre, et présentant une fréquence de coupure par exemple 3 à 25 fois supérieur à celle du signal électrique.

Selon une variante, lorsque les instants de mesure des échantillons sont synchronisés avec le signal électrique, les intégrations sont remplacées par des sélections d'une valeur maximum prise sur la période de mesure dans le premier et le second mode de réalisation du procédé de surveillance.

Un autre aspect de la présente divulgation concerne un dispositif destiné à être monté entre réseau électrique et une installation, et qui comporte un ensemble à processeur configuré pour mettre en œuvre le procédé de surveillance décrit plus haut, dans ses différentes combinaisons.

Un autre aspect concerne un produit programme d'ordinateur comportant des instructions qui lorsqu'elles sont exécutées par au moins un processeur causent la mise en œuvre du procédé de surveillance décrit plus haut.

Un autre aspect concerne un support de stockage non transitoire lisible par un ordinateur comportant des instructions qui lorsqu'elles sont exécutées par un processeur causent la mise en œuvre du procédé de surveillance décrit plus haut.

### Brève description des figures

Les exemples de réalisation seront mieux compris à la lumière de la description détaillée qui va suivre et des dessins qui l'accompagnent, lesquels sont donnés à titre d'illustration uniquement et ne sont pas limitatifs de la présente divulgation.
La figure 1 est un schéma bloc d'un premier exemple de dispositif électrique selon la présente divulgation.
La figure 2 est un organigramme d'un procédé de surveillance destiné à être mis en œuvre dans un dispositif du type de celui décrit sur la figure 1.
La figure 3 est un schéma bloc d'un second exemple de dispositif électrique selon la présente divulgation.
La figure 4 est un organigramme d'un procédé de surveillance destiné à être mis en œuvre dans un dispositif du type de celui décrit sur la figure 3.

### Description détaillée

Divers exemples de réalisation vont maintenant être décrits plus en détail, à titre non limitatif, en référence aux dessins qui accompagnent la présente divulgation et qui illustrent certains exemples de réalisation.

Dans la suite, afin de simplifier l'exposé, on décrit un dispositif électrique et un procédé de surveillance adaptés au cas d'un réseau monophasé. Ceci n'est pas limitatif. Lorsque le réseau est polyphasé, c'est-à-dire lorsqu'il délivre un signal électrique à plusieurs phases, les composants et les opérations décrits sont reproduits pour chaque phase du réseau.

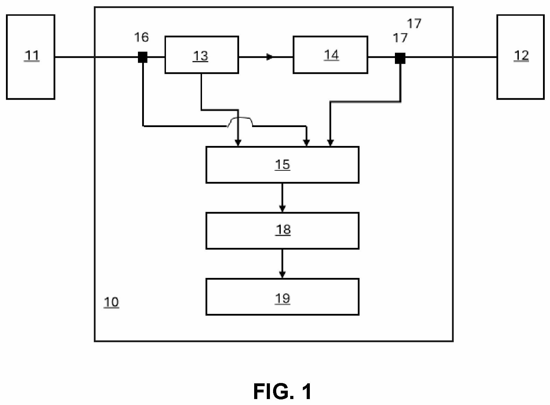

La figure 1 décrit un dispositif électrique 10 monté entre un réseau électrique monophasé 11 et une installation électrique 12. Le dispositif 10 comporte un capteur de courant 13, connecté en série avec un relai de puissance 14. Le relai de puissance 14 est connecté à l'installation électrique et permet de connecter / déconnecter l'installation 12 du réseau électrique 11. Le courant provenant du réseau électrique 11 traverse le capteur 13 puis, lorsqu'il est fermé, le relai de puissance 14. Par exemple le capteur de courant 13 est composé d'une résistance (shunt en anglais) ou d'un transformateur. Le courant I mesuré par le capteur de courant 13 est fourni à un convertisseur analogique-numérique 15. Le convertisseur analogique-numérique 15 reçoit aussi la tension V0 mesurée par un capteur de tension 16 en amont du capteur de courant 13, et la tension V1 mesurée par un capteur de tension 17 en aval du relai de puissance 14. Par exemple, les capteurs de tension sont constitués de diviseurs résistifs.

Le convertisseur analogique-numérique 15 est configuré pour obtenir à une pluralité d'instants de mesure tk (où k est un entier naturel) sur une ou plusieurs périodes de mesure, des échantillons V0(k), V1(k) et I(k) de la tension amont, de la tension aval et du courant. Typiquement la tension que l'on cherche à mesurer aux bornes du relai de puissance 14 est de quelques centaines mV alors que la tension au points amont et aval est de plusieurs centaines de Volts. Par exemple, on utilise un convertisseur du type sigma delta de 24 bits, dont la résolution est suffisante pour obtenir des mesures précises.

Ces échantillons sont fournis à un ensemble à processeur 18 du dispositif 10 qui est configuré pour déterminer, à partir des échantillons reçus, des grandeurs dont le rapport est représentatif d'une valeur de résistance du relai de puissance, et pour générer une alerte en fonction du rapport obtenu.

L'alerte est transmise, par exemple au gestionnaire du réseau électrique 11, via un modem 19 du dispositif 10.

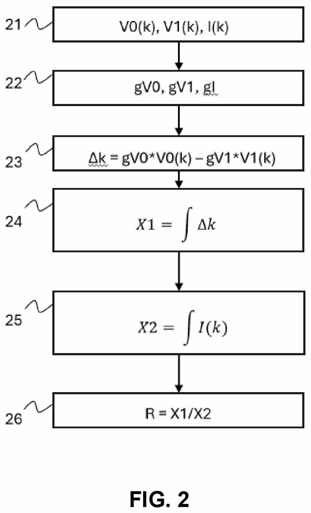

Dans l'exemple de la figure 1, les échantillons de tension amont, de tension aval et de courant sont obtenus par le même convertisseur analogique-numérique 15. Ils sont donc synchrones. Dans ce cas, avantageusement, l'ensemble à processeur 18 est configuré pour exécuter le processus décrit à la figure 2.

En 21, les échantillons de tension amont V0(k), de tension aval V1(k) et de courant I(k) sont fournis par le convertisseur analogique-numérique 15 à l'ensemble à processeur 18. En 22, un gain g_{Vo}, g_{V1}, et g_{I} respectivement est appliqué aux échantillons V0(k), V1(k) et I(k). La valeur de ces gains est déterminée pendant une phase de calibrage pour compenser l'erreur introduite par l'incertitude sur les composants des capteurs (erreur sur les résistances / sur le nombre de spires du transformateur). Les échantillons obtenus sont appelés échantillons calibrés. En 23, l'ensemble à processeur détermine, pour chaque instant de mesure tk de chaque période de mesure, une différence Δk entre les échantillons calibrés de tension amont g_{V0}*V0(k) et les échantillons calibrés de tension aval gV1*V1(k). Cette différence correspond à la tension aux bornes du contact du relai de puissance 14, car l'impédance des bras cuivre est très faible et donc négligeable devant la résistance du contact. Pour les dispositifs dont la mesure du courant est réalisée par une résistance shunt, la différence de potentiel correspond à la tension aux bornes du contact du relai de puissance 14 et de la résistance shunt.

En 24, l'ensemble à processeur 18 intègre les différences Δk sur chaque période de mesure, pour obtenir la valeur efficace de la différence de tension (« RMS value » en anglais pour « Root Mean Square »). Cette valeur efficace constitue une première grandeur X1 représentative de la tension aux bornes du relai de puissance 14 pour chaque période de mesure. En 25, il intègre les échantillons calibrés de courant I(k) sur chaque période de mesure, pour obtenir une valeur efficace du courant. La valeur efficace du courant constitue une seconde grandeur X2 représentative du courant circulant dans le relai de puissance pour chaque période de mesure. En 26, l'ensemble à processeur calcule le rapport entre la première et la seconde grandeur, ou entre une moyenne des premières et une moyenne des secondes grandeurs, pour obtenir la valeur de résistance du relai de puissance pour la ou les périodes de mesure.

La durée d'intégration peut varier. Par exemple, on peut déterminer la valeur de la résistance du relai de puissance pour chaque période du signal électrique (c'est-à-dire pour un signal électrique de 50Hz, toutes les 20ms). Il est aussi possible d'intégrer sur des durées plus longues pour obtenir des grandeurs plus moyennées et donc plus précises. Avantageusement, on intègre sur une ou plusieurs périodes entières du signal électrique.

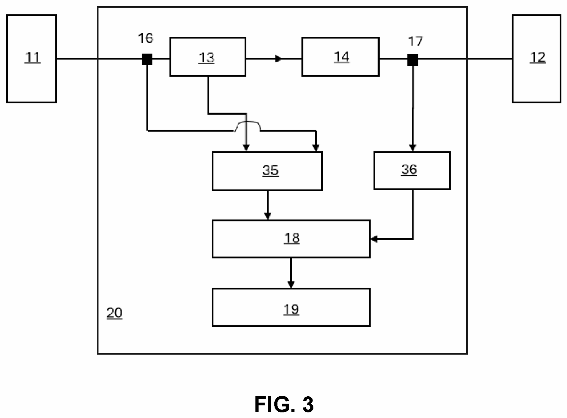

La figure 3 décrit une autre variante de dispositif électrique monté entre un réseau électrique monophasé 11 et une installation électrique 12. Le dispositif 30 diffère du dispositif 10 en ce qu'il comporte deux convertisseurs analogique-numériques 35 et 36. Le courant I mesuré par le capteur de courant 13 est fourni au premier convertisseur analogique-numérique 35. Le convertisseur analogique-numérique 35 reçoit aussi la tension V0 mesurée par un capteur de tension 16 en amont du capteur de courant 13. Il fournit à l'ensemble à processeur 18 les échantillons V0(k) et I(k). Le second convertisseur analogique-numérique 36 reçoit la tension V1 mesurée par un capteur de tension 17 en aval du relai de puissance 14. Il fournit à l'ensemble à processeur 18 les échantillons V1(k).

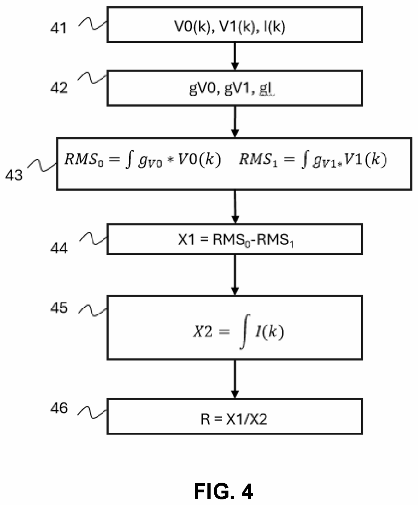

Dans l'exemple de la figure 3, les échantillons de tension amont, de tension aval et de courant sont obtenus par deux convertisseurs analogique-numériques différents, et ne sont donc pas synchrones. Dans ce cas, avantageusement, l'ensemble à processeur 18 est configuré pour exécuter le processus décrit à la figure 4. Cette configuration se trouve par exemple dans les compteurs électriques plus anciens, déjà installés dans le réseau. La version logicielle de ces compteurs peut être mise à jour pour implémenter l'algorithme décrit en référence à la figure 4.

En 41, les échantillons de tension amont V0(k) et de courant I(k) sont fournis par le convertisseur analogique-numérique 35 à l'ensemble à processeur 18. Et les échantillons de tension aval V1(k) sont fournis par le convertisseur analogique-numérique 36 à l'ensemble à processeur 18. En 42, un gain gVo, gV1, et gl respectivement est appliqué aux échantillons V0(k), V1(k) et I(k). La valeur de ces gains est déterminée pendant une phase de calibrage pour compenser l'erreur introduite par l'incertitude sur les composants des capteurs. Les échantillons obtenus sont appelés échantillons calibrés. En 43, l'ensemble à processeur intègre, les échantillons calibrés de tension amont gV0*V0(k) sur la période de mesure pour obtenir une valeur efficace de la tension amont notée RMS₀, et les échantillons calibrés de tension aval gV1*V1(k) sur la période de mesure pour obtenir une valeur efficace de la tension avale, notée RMS₁. En 44, une différence entre la valeur efficace de tension amont et la valeur efficace de tension aval est calculée. Cette différence constitue une première grandeur X1 représentative de la tension aux bornes du relai de puissance pour chaque période de mesure. En 45, l'ensemble à processeur constitue intègre les échantillons calibrés de courant I(k) sur chaque période de mesure, pour obtenir une valeur efficace du courant. La valeur efficace du courant constitue une seconde grandeur X2 représentative du courant circulant dans le relai de puissance pour chaque période de mesure. En 46, l'ensemble à processeur calcule le rapport entre la première et la seconde grandeur, ou entre une moyenne des premières et une moyenne des secondes grandeurs, pour obtenir la valeur R de résistance du relai de puissance pour la ou les périodes de mesure.

Avantageusement les échantillons correspondant à une mesure de courant faible sont ignorés car vulnérable au bruit. Par exemple, si le courant mesuré est inférieur à un seuil, les mesures associées ne sont pas prises en compte dans les calculs. Typiquement au-delà d'un courant de 10A, les mesures sont exploitables.

Dans l'exemple des figures 2 et 4, les première, seconde et troisième fonctions appliquées en 22 et 42 aux échantillons de tension amont, aval, et de courant, sont des fonctions multiplicatives qui multiplient les échantillons par des gains de calibration prédéterminés. Dans un mode de réalisation, en plus d'appliquer un gain de calibration, ces fonctions comportent un filtrage de Butterworth des échantillons calibrés, au moins du troisième ordre, et présentant une fréquence de coupure 3 à 25 fois supérieur à celle du signal.

Lorsque les instants de mesure des échantillons sont synchronisés avec le signal électrique, l'opération d'intégration peut être remplacée par la sélection de l'échantillon de valeur maximum sur la période de mesure. Par exemple, les valeurs maxima obtenues peuvent alors être moyennées sur plusieurs périodes de mesure. Cela peut être réalisé par un filtrage numérique sélectif de réponse impulsionnelle rectangulaire et de réponse en fréquence de forme sin(x)/x.

On notera que le second convertisseur 36 peut être intégré dans l'ensemble à processeur 18. Les convertisseurs intégrés sont en général moins précis (typiquement 12 bits au lieu de 24 bits pour les convertisseurs 15 ou 35). Une résolution de 12 bits est en général suffisante pour mesurer la tension au point aval.

Il est aussi possible d'utiliser le mode de réalisation de la figure 4 avec un dispositif selon la figure 1 (un seul convertisseur 15). Les résultats sont toutefois moins précis.

Les personnes du métier comprendront que tous les schémas fonctionnels présentés ici représentent des vues conceptuelles, données à titre d'exemple, de circuits incorporant les principes de la divulgation. Les détails structurels et fonctionnels spécifiques décrits ici constituent des exemples non limitatifs. L'objet de l'invention peut être réalisé sous de nombreuses formes différentes et ne doit pas être interprété comme étant limité aux seules réalisations présentées ici à titre d'exemples illustratifs, mais l'objet de l'invention n'est limité que par la portée des revendications.

## Revendications

1. Dispositif électrique destiné à être monté entre réseau électrique et une installation électrique, le réseau électrique délivrant un signal électrique à une ou plusieurs phases, le dispositif comportant au moins:
- pour chaque phase, un capteur de courant monté en série avec un relai de puissance et destiné à mesurer un courant circulant dans le relai de puissance lorsqu'il est fermé, le capteur de courant étant destiné à être connecté au réseau électrique en un point amont et le relai de puissance étant destiné à être connecté à l'installation en un point aval,
- pour chaque phase, un premier capteur de tension monté au point amont pour mesurer une tension amont, et
- pour chaque phase, un second capteur de tension monté au point aval pour mesurer une tension aval,
**caractérisé en ce que** le dispositif comprend, en outre :
- au moins un convertisseur analogique-numérique, configuré pour obtenir, pour chaque phase, à une pluralité d'instants de mesure sur une ou plusieurs périodes de mesure, des échantillons de la tension amont, de la tension aval et du courant,
- un ensemble à processeur configuré pour déterminer pour chaque phase, à partir des échantillons obtenus, des grandeurs dont le rapport est représentatif d'une valeur de résistance du relai de puissance, et générer une alerte en fonction du rapport obtenu, et
- un modem pour transmettre l'alerte.

2. Dispositif électrique selon la revendication 1, **caractérisé en ce que** les échantillons de tension amont, de tension aval et de courant sont obtenus à partir d'un même convertisseur analogique-numérique, et l'ensemble à processeur est configuré pour, pour chaque phase :
- déterminer, pour chaque instant de mesure de chaque période de mesure, une différence entre une première fonction des échantillons de tension amont et une seconde fonction des échantillons de tension aval,
- intégrer les différences déterminées sur chaque période de mesure, pour obtenir une première grandeur représentative d'une tension aux bornes du relai de puissance pour chaque période de mesure,
- intégrer une troisième fonction des échantillons de courant sur chaque période de mesure, pour obtenir une seconde grandeur représentative du courant circulant dans le relai de puissance pour chaque période de mesure,
- calculer le rapport entre la première et la seconde grandeur, ou entre une moyenne des premières et une moyenne des secondes grandeurs, pour obtenir la valeur de résistance du relai de puissance pour la ou les périodes de mesure.

3. Dispositif électrique selon la revendication 1, **caractérisé en ce que** les échantillons sont obtenus à partir d'une pluralité de convertisseurs analogique-numérique et l'ensemble à processeur est configuré pour, pour chaque phase :
- intégrer une première fonction des échantillons de tension amont sur chaque période de mesure pour obtenir une valeur représentative de la tension amont,
- intégrer une seconde fonction des échantillons de tension aval sur chaque période de mesure pour obtenir une valeur représentative de la tension aval,
- déterminer une différence entre la valeur représentative de la tension amont et la valeur représentative de la tension aval, pour obtenir une première grandeur représentative d'une tension aux bornes du relai de puissance pour chaque période de mesure,
- intégrer une troisième fonction des échantillons de courant sur chaque période de mesure, pour obtenir une seconde grandeur représentative du courant circulant dans le relai de puissance pour chaque période de mesure,
- calculer le rapport entre la première et la seconde grandeur, ou entre une moyenne des premières et une moyenne des secondes grandeurs, pour obtenir la valeur de résistance du relai de puissance pour la ou les périodes de mesure.

4. Dispositif selon l'une des revendications 1 à 3, **caractérisé en ce que** la première, la seconde et la troisième fonction comportent respectivement une multiplication des échantillons de tension amont, de tension aval et de courant, par respectivement un gain de tension amont, de tension aval et de courant.

5. Dispositif électrique selon l'une des revendications 2 à 4, **caractérisé en ce que** la moyenne des premières grandeurs et la moyenne des secondes grandeurs sont obtenues en appliquant un filtrage numérique sélectif de réponse impulsionnelle rectangulaire et de réponse en fréquence de forme sin(x)/x.

6. Dispositif selon l'une des revendications 2 à 5, caractérisé en que la première, la seconde et la troisième fonction comportent respectivement un filtrage de Butterworth desdits échantillons, au moins du troisième ordre, et présentant une fréquence de coupure 3 à 25 fois supérieur à celle du signal.

7. Dispositif selon l'une des revendications 1 à 6, **caractérisé en ce qu'**une période de mesure comporte une ou plusieurs périodes entières du signal.

8. Dispositif selon l'une des revendications 1 à 7, **caractérisé en ce que** lorsque les instants de mesure des échantillons sont synchronisés avec le signal électrique, l'ensemble à processeur est configuré pour, au lieu d'intégrer, sélectionner une valeur maximum prise sur la période de mesure.

9. Dispositif selon l'une des revendications 1 à 8, **caractérisé en ce que** l'ensemble à processeur est configuré pour ignorer les échantillons associés à une mesure de courant vulnérable au bruit.

10. Procédé de surveillance d'un dispositif électrique destiné à être monté entre réseau électrique et une installation, le réseau électrique délivrant un signal électrique à une ou plusieurs phases, le dispositif comportant au moins:
- pour chaque phase, un capteur de courant monté en série avec un relai de puissance et destiné à mesurer un courant circulant dans le relai de puissance lorsqu'il est fermé, le capteur de courant étant destiné à être connecté au réseau électrique en un point amont et le relai de puissance étant destiné à être connecté à l'installation en un point aval,
- pour chaque phase, un premier capteur de tension monté au point amont pour mesurer une tension amont,
- pour chaque phase, un second capteur de tension monté au point aval pour mesurer une tension aval,
- au moins un convertisseur analogique-numérique, configuré pour obtenir, pour chaque phase, à une pluralité d'instants de mesure sur une ou plusieurs périodes de mesure, des échantillons de la tension amont, de la tension aval et du courant,
- un modem de transmission,
le procédé de surveillance comportant :
- une détermination pour chaque phase, à partir des échantillons obtenus, de grandeurs dont le rapport est représentatif d'une valeur de résistance du relai de puissance pour la période de mesure,
- une génération d'alerte en fonction du rapport obtenu, et
- une transmission d'alerte via le modem de transmission.

11. Procédé de surveillance selon la revendication 10, **caractérisé en ce que** les échantillons de tension amont, de tension aval et de courant sont obtenus à partir d'un même convertisseur analogique-numérique, et le procédé comporte :
- une détermination, pour chaque instant de mesure de chaque période de mesure, une différence entre une première fonction des échantillons de tension amont et une seconde fonction des échantillons de tension aval,
- une intégration des différences déterminées sur chaque période de mesure, pour obtenir une première grandeur représentative d'une tension aux bornes du relai de puissance pour chaque période de mesure,
- une intégration d'une troisième fonction des échantillons de courant sur chaque période de mesure, pour obtenir une seconde grandeur représentative du courant circulant dans le relai de puissance pour chaque période de mesure,
- un calcul d'un rapport entre la première et la seconde grandeur, ou entre une moyenne des premières et une moyenne des secondes grandeurs, pour obtenir la valeur de résistance du relai de puissance pour la ou les périodes de mesure.

12. Procédé de surveillance selon la revendication 10, **caractérisé en ce que** les échantillons sont obtenus à partir d'une pluralité de convertisseurs analogique-numérique et le procédé comporte pour chaque phase :
- une intégration d'une première fonction des échantillons de tension amont sur chaque période de mesure pour obtenir une valeur représentative de la tension amont,
- une intégration d'une seconde fonction des échantillons de tension aval sur chaque période de mesure pour obtenir une valeur représentative de la tension aval,
- une détermination d'une différence entre la valeur représentative de la tension amont et la valeur représentative de la tension aval, pour obtenir une première grandeur représentative d'une tension aux bornes du relai de puissance pour chaque période de mesure,
- une intégration d'une troisième fonction des échantillons de courant sur chaque période de mesure, pour obtenir une seconde grandeur représentative du courant circulant dans le relai de puissance pour chaque période de mesure,
- un calcul d'un rapport entre la première et la seconde grandeur, ou entre une moyenne des premières et une moyenne des secondes grandeurs, pour obtenir la valeur de résistance du relai de puissance pour la ou les périodes de mesure.

13. Procédé de surveillance selon l'une des revendications 11 ou 12, **caractérisé en ce que** la première, la seconde et la troisième fonction comportent respectivement une multiplication des échantillons de tension amont, de tension aval et de courant, par respectivement un gain de tension amont, de tension aval et de courant.

14. Procédé de surveillance selon l'une des revendications 10 à 13, **caractérisé en ce que** la moyenne des premières grandeurs et la moyenne des secondes grandeurs sont obtenues en appliquant un filtrage numérique sélectif de réponse impulsionnelle rectangulaire et de réponse en fréquence de forme sin(x)/x.

15. Procédé de surveillance selon l'une des revendications 11 à 14, caractérisé en que la première, la seconde et la troisième fonction comportent respectivement un filtrage de Butterworth desdits échantillons, au moins du troisième ordre, et présentant une fréquence de coupure 3 à 25 fois supérieur à celle du signal.

16. Procédé de surveillance selon l'une des revendications 10 à 15, **caractérisé en ce que** lorsque les instants de mesure des échantillons sont synchronisés avec le signal électrique, les intégrations sont remplacées par des sélections d'une valeur maximum prise sur la période de mesure.

17. Procédé de surveillance selon l'une des revendications 10 à 16, **caractérisé en ce qu'**il ignore les échantillons ayant une amplitude les rendant vulnérables au bruit.

18. Produit programme d'ordinateur comportant des instructions qui lorsqu'elles sont exécutées par au moins un processeur conduisent le dispositif selon l'une quelconque des revendications 1 à 9 à causer la mise en œuvre d'un procédé selon l'une quelconque des revendications 10 à 17.

19. Support de stockage non transitoire lisible par un ordinateur comportant des instructions qui lorsqu'elles sont exécutées par un processeur conduisent le dispositif selon l'une quelconque des revendications 1 à 9 à causer la mise en œuvre d'un procédé selon l'une quelconque des revendications 10 à 17.

## Patentansprüche

1. Elektrische Vorrichtung, die dazu bestimmt ist, zwischen einem Stromnetz und einer elektrischen Anlage montiert zu werden, wobei das Stromnetz ein elektrisches Signal mit einer oder mehreren Phasen liefert, wobei die Vorrichtung mindestens aufweist:
- für jede Phase einen Stromsensor, der in Reihe mit einem Leistungsrelais geschaltet und dazu bestimmt ist, einen Strom zu messen, der in dem Leistungsrelais fließt, wenn dieses geschlossen ist, wobei der Stromsensor dazu bestimmt ist, an einem stromaufwärtigen Punkt mit dem Stromnetz verbunden zu sein, und das Leistungsrelais dazu bestimmt ist, an einem stromabwärtigen Punkt mit der Anlage verbunden zu sein,
- für jede Phase einen ersten Spannungssensor, der an dem stromaufwärtigen Punkt montiert ist, zum Messen einer stromaufwärtigen Spannung, und
- für jede Phase einen zweiten Spannungssensor, der an dem stromabwärtigen Punkt montiert ist, zum Messen einer stromabwärtigen Spannung,
**dadurch gekennzeichnet, dass** die Vorrichtung ferner umfasst:
- mindestens einen Analog-Digital-Wandler, der zum Erhalten, für jede Phase, zu einer Vielzahl von Messzeitpunkten über eine oder mehrere Messperioden, von Abtastwerten der stromaufwärtigen Spannung, der stromabwärtigen Spannung und des Stroms konfiguriert ist,
- eine Prozessoranordnung, die zum Bestimmen für jede Phase, aus den erhaltenen Abtastwerten, von Größen, deren Verhältnis einen Widerstandswert des Leistungsrelais darstellt, und zum Erzeugen eines Alarms in Abhängigkeit von dem erhaltenen Verhältnis konfiguriert ist, und
- ein Modem zum Übertragen des Alarms.

2. Elektrische Vorrichtung nach Anspruch 1,
**dadurch gekennzeichnet, dass** die Abtastwerte der stromaufwärtigen Spannung, der stromabwärtigen Spannung und des Stroms von demselben Analog-Digital-Wandler erhalten werden und die Prozessoranordnung konfiguriert ist zum, für jede Phase:
- Bestimmen, für jeden Messzeitpunkt jeder Messperiode, einer Differenz zwischen einer ersten Funktion der Abtastwerte der stromaufwärtigen Spannung und einer zweiten Funktion der Abtastwerte der stromabwärtigen Spannung,
- Integrieren der Differenzen, die über jede Messperiode bestimmt werden, zum Erhalten einer ersten Größe, die eine Spannung an den Klemmen des Leistungsrelais für jede Messperiode darstellt,
- Integrieren einer dritten Funktion der Stromabtastwerte über jede Messperiode zum Erhalten einer zweiten Größe, die den Strom, der in dem Leistungsrelais fließt, für jede Messperiode darstellt,
- Berechnen des Verhältnisses zwischen der ersten und der zweiten Größe oder zwischen einem Mittelwert der ersten und einem Mittelwert der zweiten Größen zum Erhalten des Widerstandswerts des Leistungsrelais für die eine oder die mehreren Messperioden.

3. Elektrische Vorrichtung nach Anspruch 1,
**dadurch gekennzeichnet, dass** die Abtastwerte aus einer Vielzahl von Analog-Digital-Wandlern erhalten werden und die Prozessoranordnung konfiguriert ist zum, für jede Phase:
- Integrieren einer ersten Funktion der Abtastwerte der stromaufwärtigen Spannung über jede Messperiode zum Erhalten eines darstellenden Werts der stromaufwärtigen Spannung,
- Integrieren einer zweiten Funktion der Abtastwerte der stromabwärtigen Spannung über jede Messperiode zum Erhalten eines darstellenden Werts der stromabwärtigen Spannung,
- Bestimmen einer Differenz zwischen dem Wert, der die stromaufwärtige Spannung darstellt, und dem Wert, der die stromabwärtige Spannung darstellt, zum Erhalten einer ersten Größe, die eine Spannung an den Klemmen des Leistungsrelais darstellt, für jede Messperiode,
- Integrieren einer dritten Funktion der Stromabtastwerte über jede Messperiode zum Erhalten einer zweiten Größe, die den Strom, der in dem Leistungsrelais fließt, für jede Messperiode darstellt,
- Berechnen des Verhältnisses zwischen der ersten und der zweiten Größe oder zwischen einem Mittelwert der ersten und einem Mittelwert der zweiten Größen zum Erhalten des Widerstandswerts des Leistungsrelais für die eine oder die mehreren Messperioden.

4. Vorrichtung nach einem der Ansprüche 1 bis 3,
**dadurch gekennzeichnet, dass** die erste, die zweite und die dritte Funktion jeweils eine Multiplikation der Abtastwerte der stromaufwärtigen Spannung, der stromabwärtigen Spannung und des Stroms mit jeweils einer Verstärkung der stromaufwärtigen Spannung, der stromabwärtigen Spannung und des Stroms aufweisen.

5. Elektrische Vorrichtung nach einem der Ansprüche 2 bis 4,
**dadurch gekennzeichnet, dass** der Mittelwert der ersten Größen und der Mittelwert der zweiten Größen durch Anwenden einer selektiven digitalen Filterung mit rechteckiger Impulsantwort und einem Frequenzgang der Form sin(x)/x erhalten werden.

6. Vorrichtung nach einem der Ansprüche 2 bis 5,
**dadurch gekennzeichnet, dass** die erste, die zweite und die dritte Funktion jeweils eine Butterworth-Filterung der Abtastwerte mindestens dritter Ordnung aufweisen und eine Grenzfrequenz vorweisen, die 3- bis 25-mal höher als die des Signals ist.

7. Vorrichtung nach einem der Ansprüche 1 bis 6,
**dadurch gekennzeichnet, dass** eine Messperiode eine oder mehrere ganze Perioden des Signals aufweist.

8. Vorrichtung nach einem der Ansprüche 1 bis 7,
**dadurch gekennzeichnet, dass**, wenn die Messzeitpunkte der Abtastwerte mit dem elektrischen Signal synchronisiert sind, die Prozessoranordnung zum Auswählen, statt Integrieren, eines Maximalwerts konfiguriert ist, der über die Messperiode erfasst wird.

9. Vorrichtung nach einem der Ansprüche 1 bis 8,
**dadurch gekennzeichnet, dass** die Prozessoranordnung zum Ignorieren der Abtastwerte konfiguriert ist, die einer rauschanfälligen Strommessung zugeordnet sind.

10. Verfahren zum Überwachen einer elektrischen Vorrichtung, die dazu bestimmt ist, zwischen einem elektrischen Netz und einer Anlage montiert zu werden, wobei das elektrische Netz ein elektrisches Signal mit einer oder mehreren Phasen liefert, wobei die Vorrichtung mindestens aufweist:
- für jede Phase einen Stromsensor, der in Reihe mit einem Leistungsrelais geschaltet und dazu bestimmt ist, einen Strom zu messen, der in dem Leistungsrelais fließt, wenn dieses geschlossen ist, wobei der Stromsensor dazu bestimmt ist, an einem stromaufwärtigen Punkt mit dem Stromnetz verbunden zu sein, und das Leistungsrelais dazu bestimmt ist, an einem stromabwärtigen Punkt mit der Anlage verbunden zu sein,
- für jede Phase einen ersten Spannungssensor, der an dem stromaufwärtigen Punkt montiert ist, zum Messen einer stromaufwärtigen Spannung,
- für jede Phase einen zweiten Spannungssensor, der an dem stromabwärtigen Punkt montiert ist, zum Messen einer stromabwärtigen Spannung,
- mindestens einen Analog-Digital-Wandler, der zum Erhalten, für jede Phase, zu einer Vielzahl von Messzeitpunkten über eine oder mehrere Messperioden, von Abtastwerten der stromaufwärtigen Spannung, der stromabwärtigen Spannung und des Stroms konfiguriert ist,
- ein Übertragungsmodem,
wobei das Überwachungsverfahren aufweist:
- ein Bestimmen für jede Phase, aus den erhaltenen Abtastwerten, von Größen, deren Verhältnis einen Widerstandswert des Leistungsrelais für die Messperiode darstellt,
- ein Erzeugen einer Warnung in Abhängigkeit von dem erhaltenen Verhältnis, und
- eine Alarmübertragung über das Übertragungsmodem.

11. Überwachungsverfahren nach Anspruch 10,
**dadurch gekennzeichnet, dass** die Abtastwerte der stromaufwärtigen Spannung, der stromabwärtigen Spannung und des Stroms von demselben Analog-Digital-Wandler erhalten werden, und das Verfahren aufweist:
- ein Bestimmen, für jeden Messzeitpunkt jeder Messperiode, einer Differenz zwischen einer ersten Funktion der Abtastwerte der stromaufwärtigen Spannung und einer zweiten Funktion der Abtastwerte der stromabwärtigen Spannung,
- ein Integrieren der Differenzen, die über jede Messperiode bestimmt werden, zum Erhalten einer ersten Größe, die eine Spannung an den Klemmen des Leistungsrelais für jede Messperiode darstellt,
- ein Integrieren einer dritten Funktion der Stromabtastwerte über jede Messperiode, zum Erhalten einer zweiten Größe, die den Strom, der in dem Leistungsrelais fließt, für jede Messperiode darstellt,
- ein Berechnen des Verhältnisses zwischen der ersten und der zweiten Größe oder zwischen einem Mittelwert der ersten und einem Mittelwert der zweiten Größen zum Erhalten des Widerstandswerts des Leistungsrelais für die eine oder die mehreren Messperioden.

12. Überwachungsverfahren nach Anspruch 10,
**dadurch gekennzeichnet, dass** die Abtastwerte aus einer Vielzahl von Analog-Digital-Wandlern erhalten werden und das Verfahren für jede Phase aufweist:
- ein Integrieren einer ersten Funktion der Abtastwerte der stromaufwärtigen Spannung über jede Messperiode zum Erhalten eines darstellenden Werts der stromaufwärtigen Spannung,
- ein Integrieren einer zweiten Funktion der Abtastwerte der stromabwärtigen Spannung über jede Messperiode zum Erhalten eines darstellenden Werts der stromabwärtigen Spannung,
- ein Bestimmen einer Differenz zwischen dem Wert, der die stromaufwärtige Spannung darstellt, und dem Wert, der die stromabwärtige Spannung darstellt, zum Erhalten einer ersten Größe, die eine Spannung an den Klemmen des Leistungsrelais darstellt, für jede Messperiode,
- ein Integrieren einer dritten Funktion der Stromabtastwerte über jede Messperiode, zum Erhalten einer zweiten Größe, die den Strom, der in dem Leistungsrelais fließt, für jede Messperiode darstellt,
- ein Berechnen des Verhältnisses zwischen der ersten und der zweiten Größe oder zwischen einem Mittelwert der ersten und einem Mittelwert der zweiten Größen zum Erhalten des Widerstandswerts des Leistungsrelais für die eine oder die mehreren Messperioden.

13. Überwachungsverfahren nach einem der Ansprüche 11 oder 12, **dadurch gekennzeichnet, dass** die erste, die zweite und die dritte Funktion jeweils eine Multiplikation der Abtastwerte der stromaufwärtigen Spannung, der stromabwärtigen Spannung und des Stroms mit jeweils einer Verstärkung der stromaufwärtigen Spannung, der stromabwärtigen Spannung und des Stroms aufweisen.

14. Überwachungsverfahren nach einem der Ansprüche 10 bis 13,
**dadurch gekennzeichnet, dass** der Mittelwert der ersten Größen und der Mittelwert der zweiten Größen durch Anwenden einer selektiven digitalen Filterung mit rechteckiger Impulsantwort und einem Frequenzgang der Form sin(x)/x erhalten werden.

15. Überwachungsverfahren nach einem der Ansprüche 11 bis 14, **dadurch gekennzeichnet, dass** die erste, die zweite und die dritte Funktion jeweils eine Butterworth-Filterung der Abtastwerte mindestens dritter Ordnung aufweisen und eine Grenzfrequenz vorweisen, die 3- bis 25-mal höher als die des Signals ist.

16. Überwachungsverfahren nach einem der Ansprüche 10 bis 15, **dadurch gekennzeichnet, dass**, wenn die Messzeitpunkte der Abtastwerte mit dem elektrischen Signal synchronisiert sind, die Integrationen durch Auswahlen eines Maximalwerts ersetzt werden, der über die Messperiode erfasst wird.

17. Überwachungsverfahren nach einem der Ansprüche 10 bis 16, **dadurch gekennzeichnet, dass** es Abtastwerte ignoriert, die eine Amplitude aufweisen, die sie rauschanfällig macht.

18. Computerprogrammprodukt, das Anweisungen aufweist, die, wenn sie durch mindestens einen Prozessor ausgeführt werden, die Vorrichtung nach einem der Ansprüche 1 bis 9 dazu bringen, das Implementieren eines Verfahrens nach einem der Ansprüche 10 bis 17 zu veranlassen.

19. Nichtflüchtiger, computerlesbarer Speicherträger, der Anweisungen aufweist, die, wenn sie durch einen Prozessor ausgeführt werden, die Vorrichtung nach einem der Ansprüche 1 bis 9 dazu bringen, das Implementieren eines Verfahrens nach einem der Ansprüche 10 bis 17 zu veranlassen.

## Claims

1. An electrical device intended to be mounted between an electrical network and an electrical installation, the electrical network delivering an electrical signal to one or more phases, the device comprising at least:
- for each phase, a current sensor mounted in series with a power relay and intended to measure a current flowing in the power relay when it is closed, the current sensor being intended to be connected to the electrical network at an upstream point and the power relay being intended to be connected to the installation at a downstream point,
- for each phase, a first voltage sensor mounted at the upstream point to measure an upstream voltage,
- for each phase, a second voltage sensor mounted at the downstream point to measure a downstream voltage,
**characterized in that** the device further comprises:
- at least one analog-to-digital converter configured to obtain, for each phase and at a plurality of measurement times over one or more measurement periods, samples of the upstream voltage, the downstream voltage and the current,
- a processor assembly configured to determine, for each phase and from the samples obtained, magnitudes of which the ratio is representative of a resistance value of the power relay, and to generate an alert based on the ratio obtained, and
- a modem to transmit the alert.

2. The electrical device according to claim 1, **characterized in that** the samples of upstream voltage, downstream voltage and current are obtained from the same analog-to-digital converter, and the processor assembly is configured to, for each phase:
- determine, for each measurement time of each measurement period, a difference between a first function of the upstream voltage samples and a second function of the downstream voltage samples,
- integrate the differences determined over each measurement period to obtain a first magnitude representative of a voltage at the terminals of the power relay for each measurement period,
- integrate a third function of the current samples over each measurement period to obtain a second magnitude representative of the current flowing in the power relay for each measurement period,
- calculate the ratio between the first and the second magnitude or between an average of the first magnitudes and an average of the second magnitudes to obtain the resistance value of the power relay for the measurement period(s).

3. The electrical device according to claim 1, **characterized in that** the samples are obtained from a plurality of analog-to-digital converters and the processor assembly is configured to, for each phase:
- integrate a first function of the upstream voltage samples over each measurement period to obtain a value representative of the upstream voltage,
- integrate a second function of the downstream voltage samples over each measurement period to obtain a value representative of the downstream voltage,
- determine a difference between the value representative of the upstream voltage and the value representative of the downstream voltage to obtain a first magnitude representative of a voltage at the terminals of the power relay for each measurement period,
- integrate a third function of the current samples over each measurement period to obtain a second magnitude representative of the current flowing in the power relay for each measurement period,
- calculate the ratio between the first and the second magnitude or between an average of the first magnitudes and an average of the second magnitudes to obtain the resistance value of the power relay for the measurement period(s).

4. The device according to any of claims 1 to 3, **characterized in that** the first, the second and the third function each comprise multiplication of the samples of upstream voltage, downstream voltage and current by a gain of upstream voltage, downstream voltage and current, respectively.

5. The electrical device according to any of claims 2 to 4,
**characterized in that** the average of the first magnitudes and the average of the second magnitudes are obtained by applying selective digital filtering of rectangular impulse response and sin(x)/x frequency response.

6. The device according to any of claims 2 to 5, **characterized in that** the first, the second and the third function each comprise Butterworth filtering of said samples, at least of the third order, and presenting a cutoff frequency 3 to 25 times greater than that of the signal.

7. The device according to any of claims 1 to 6, **characterized in that** a measurement period comprises one or more whole signal periods.

8. The device according to any of claims 1 to 7, **characterized in that** when the measurement times of the samples are synchronized with the electrical signal, the processor assembly is configured to select, instead of integrate, a maximum value taken over the measurement period.

9. The device according to any of claims 1 to 8, **characterized in that** the processor assembly is configured to disregard the samples associated with a current measurement prone to noise.

10. A method for monitoring an electrical device intended to be mounted between an electrical network and an installation, the electrical network delivering an electrical signal to one or more phases, the device comprising at least:
- for each phase, a current sensor mounted in series with a power relay and intended to measure a current flowing in the power relay when it is closed, the current sensor being intended to be connected to the electrical network at an upstream point and the power relay being intended to be connected to the installation at a downstream point,
- for each phase, a first voltage sensor mounted at the upstream point to measure an upstream voltage,
- for each phase, a second voltage sensor mounted at the downstream point to measure a downstream voltage,
- at least one analog-to-digital converter configured to obtain, for each phase and at a plurality of measurement times over one or more measurement periods, samples of the upstream voltage, the downstream voltage and the current,
- a transmission modem,
the monitoring method comprising:
- determining, for each phase and from the samples obtained, magnitudes of which the ratio is representative of a resistance value of the power relay for the measurement period,
- generating an alert based on the ratio obtained, and
- transmitting an alert via the transmission modem.

11. The monitoring method according to claim 10, **characterized in that** the samples of upstream voltage, downstream voltage and current are obtained from the same analog-to-digital converter, and the method comprises:
- determining, for each measurement time of each measurement period, a difference between a first function of the upstream voltage samples and a second function of the downstream voltage samples,
- integrating the differences determined over each measurement period to obtain a first magnitude representative of a voltage at the terminals of the power relay for each measurement period,
- integrating a third function of the current samples over each measurement period to obtain a second magnitude representative of the current flowing in the power relay for each measurement period,
- calculating a ratio between the first and the second magnitude or between an average of the first magnitudes and an average of the second magnitudes to obtain the resistance value of the power relay for the measurement period(s).

12. The monitoring method according to claim 10, **characterized in that** the samples are obtained from a plurality of analog-to-digital converters and the method comprises, for each phase:
- integrating a first function of the upstream voltage samples over each measurement period to obtain a value representative of the upstream voltage,
- integrating a second function of the downstream voltage samples over each measurement period to obtain a value representative of the downstream voltage,
- determining a difference between the value representative of the upstream voltage and the value representative of the downstream voltage to obtain a first magnitude representative of a voltage at the terminals of the power relay for each measurement period,
- integrating a third function of the current samples over each measurement period to obtain a second magnitude representative of the current flowing in the power relay for each measurement period,
- calculating a ratio between the first and the second magnitude or between an average of the first magnitudes and an average of the second magnitudes to obtain the resistance value of the power relay for the measurement period(s).

13. The monitoring method according to either of claims 11 or 12, **characterized in that** the first, the second and the third function each comprise a multiplication of the samples of upstream voltage, downstream voltage and current by a gain of upstream voltage, downstream voltage and current, respectively.

14. The monitoring method according to any of claims 10 to 13, **characterized in that** the average of the first magnitudes and the average of the second magnitudes are obtained by applying selective digital filtering of rectangular impulse response and sin(x)/x frequency response.

15. The monitoring method according to any of claims 11 to 14, **characterized in that** the first, the second, and the third function each comprise Butterworth filtering of said samples, at least of the third order, and presenting a cutoff frequency 3 to 25 times greater than that of the signal.

16. The monitoring method according to any of claims 10 to 15, **characterized in that** when the measurement times of the samples are synchronized with the electrical signal, the integrations are replaced by selections of a maximum value taken over the measurement period.

17. The monitoring method according to any of claims 10 to 16, **characterized in that** it disregards samples having an amplitude that makes them prone to noise.

18. A computer program product comprising instructions which, when performed by at least one processor, cause the device according to any of claims 1 to 9 to implement a method according to any of claims 10 to 17.

19. A non-transitory computer-readable storage medium comprising instructions which, when performed by a processor, cause the device according to any of claims 1 to 9 to implement a method according to any of claims 10 to 17.
